(19) Europäisches Patentamt
European Patent Office
Office européen des brevets

(11) **EP 2 313 792 B1**

(12) **EUROPÄISCHE PATENTSCHRIFT**

(45) Veröffentlichungstag und Bekanntmachung des Hinweises auf die Patenterteilung:
**26.04.2017 Patentblatt 2017/17**

(21) Anmeldenummer: **09757231.7**

(22) Anmeldetag: **29.05.2009**

(51) Int Cl.:
*G01R 31/36* (2006.01)       *H02J 9/06* (2006.01)
*F03D 7/02* (2006.01)       *G01R 31/34* (2006.01)

(86) Internationale Anmeldenummer:
**PCT/EP2009/003842**

(87) Internationale Veröffentlichungsnummer:
**WO 2009/146848 (10.12.2009 Gazette 2009/50)**

(54) **ÜBERWACHUNGSEINRICHTUNG FÜR PITCHSYSTEME VON WINDENERGIEANLAGEN**

MONITORING DEVICE FOR PITCH SYSTEMS OF WIND ENERGY SYSTEMS

DISPOSITIF DE SURVEILLANCE POUR DES SYSTÈMES PITCH (RÉGLAGE À PAS VARIABLE DE L'ANGLE DE CALAGE DES PALES) D'ÉOLIENNES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **30.05.2008 DE 102008025944**

(43) Veröffentlichungstag der Anmeldung:
**27.04.2011 Patentblatt 2011/17**

(73) Patentinhaber: **Senvion GmbH**
**22297 Hamburg (DE)**

(72) Erfinder:
• **LETAS, Heinz-Hermann**
**24796 Bovenau (DE)**

• **PETERS, Matthias**
**24806 Sophienhamm (DE)**

(74) Vertreter: **Glawe, Delfs, Moll**
**Partnerschaft mbB**
**von Patent- und Rechtsanwälten**
**Postfach 13 03 91**
**20103 Hamburg (DE)**

(56) Entgegenhaltungen:
**EP-A2- 1 739 807       DE-A1- 2 043 660**
**DE-A1- 10 261 491       DE-U1-202006 018 866**
**GB-A- 1 175 119       US-A- 3 529 230**
**US-A1- 2006 273 783**

**EP 2 313 792 B1**

**Beschreibung**

Die Erfindung betrifft eine Überwachungseinrichtung für Pitchsysteme von Windenergieanlagen. Genauer gesagt betrifft sie Windenergieanlagen mit einem Rotor, einem davon angetriebenen Generator zur Erzeugung elektrischer Energie, wobei der Rotor mindestens ein mit einer Pitcheinrichtung verstellbares Blatt aufweist, wobei die Pitcheinrichtung eine Energieversorgung mittels einer Batterie und einen Stellantrieb umfasst, und wobei eine Kontrolleinheit für die Batterie der Pitcheinrichtung vorgesehen ist.

Windenergieanlagen der eingangs genannten Art weisen verstellbare Rotorblätter auf, die bezüglich ihres Anstellwinkels zum einfallenden Wind veränderbar sind. Derartige Pitchsysteme ermöglichen zwei verschiedene Funktionalitäten, nämlich einerseits einen drehzahlvariablen Betrieb und andererseits eine Stillsetzung der Windenergieanlage. Letzteres geschieht dadurch, dass die Rotorblätter in eine Fahnenstellung gebracht werden, in welcher sie vom Wind nicht mehr in eine Drehbewegung versetzt werden. Gerade letztere Funktionalität ist ausgesprochen wichtig, da sie als Bremsfunktion fungiert. Sie ist ein besonders sicherheitskritischer Aspekt für die Windenergieanlage. Um über die Pitchverstellung ein Stillsetzen auch bei Ausfall der Stromversorgung der Windenergieanlage gewährleisten zu können, sind für die Pitcheinrichtung meist eigene Akkumulatorsysteme vorgesehen. Sie gewährleisten die Stromversorgung der Pitcheinrichtung auch bei Netzausfall. Als Energiespeicher werden herkömmliche aufladbare Akkumulatoren verwendet oder auch Kondensatoren mit besonders hoher Kapazität (s.g. Ultra-Caps). Ganz unabhängig davon, welche Bauweise genau für die Akkumulatoren verwendet wird, so haftet ihnen doch der gemeinsame Nachteil an, dass es Verschleißteile sind. Um wegen der sicherheitskritischen Funktionalität ein Ausfallen der Pitcheinrichtung wegen eines möglicherweise defekten Akkumulators sicher zu vermeiden, werden die Akkumulatoren in regelmäßigen Zeitabständen überprüft. Dazu sind verschiedene Verfahren im Stand der Technik bekannt geworden.

Aus der DE 10 2005 030 709 ist bekannt, dass die Lebensdauer der Akkumlatoren dadurch verlängert wird, dass die Belastungs- und Ladevorgänge optimiert werden, indem strombegrenzende Maßnahmen verwendet werden, die Temperatur der Akkumulatoren überwacht und die Klemmenspannung der einzelnen Akkumulatoren gemessen wird.

Ein weiteres Beispiel aus dem Stand der Technik ist aus der EP1739807 bekannt.

Der Erfindung liegt die Aufgabe zu Grunde, ausgehend von der genannten Methode eine verbesserte Überwachungseinrichtung bzw. Verfahren anzugeben, welche weniger fehleranfällig sind.

Die erfindungsgemäße Lösung liegt in den Merkmalen der unabhängigen Ansprüche. Vorteilhafte Weiterbildungen sind Gegenstand der abhängigen Ansprüche.

Bei einer Windenergieanlage mit einem Rotor, einem davon angetriebenen Generator zur Erzeugung elektrischer Energie, wobei der Rotor mindestens ein mittels einer Pitcheinrichtung verstellbares Blatt aufweist, und die Pitcheinrichtung eine Energieversorgungseinheit mit einer Batterie und einen Stellantrieb sowie eine Kontrolleinheit umfasst, ist gemäß der Erfindung vorgesehen ein Belastungsmodul, welches den Stellantrieb zwischen einem Betriebsmodus und einem Prüfmodus umschaltet, wobei im Prüfmodus der Stellantrieb eine vorwählbare definierte Last für die Batterie bildet. Mit ihr kann die Batterie beaufschlagt werden und ihr Verhalten unter dieser Belastung (Stress-Test) geprüft werden.

Unter einer Batterie wird ein Speicher für elektrische Energie verstanden. Insbesondere kann es sich um einen wiederaufladbaren Akkumulator oder einen Hochkapazitäts-Kondensator (Ultra-Cap) handeln.

Die Erfindung beruht auf dem Gedanken, mit dem Stellantrieb im Prüfmodus definierte Rahmenbedingungen zu schaffen, unter denen die Energieversorgungseinheit der Pitcheinrichtung auf ihre Güte geprüft werden kann. Mit dem Aufschalten einer bekannten, wohldeterminierten Last können reproduzierbare Bedingungen für den Test geschaffen werden. Damit wird es ermöglicht, auch zeitlich nacheinander liegende Messungen miteinander vergleichen zu können. Veränderungen der Batterien über die Zeit hinweg können erkannt und bei der Bestimmung der Austauschreife berücksichtigt werden. Weiter bieten die reproduzierbaren Messungen den Vorteil, dass präzisere Grenzwerte gesetzt werden können. Dies erhöht nicht nur die Qualität der Messung, sondern erlaubt auch den Verzicht auf Sicherheitsmargen als Puffer gegenüber nicht beeinflussbaren Umweltschwankungen, so dass die Batterien bis zu ihrer tatsächlichen Austauschreife genutzt werden können. Der herkömmlicherweise aus Sicherheitsgründen im Zweifel eher vorzeitig vorgenommene Austausch ist damit nicht mehr erforderlich, was den Kostenaufwand senkt. Gleichzeitig wird durch die reproduzierbaren Bedingungen vermieden, dass an sich austauschreife Batterien auf Grund für sie günstigerer Testbedingungen noch als weiter einsatzfähig fehlklassifiziert werden. Eine solche Fehlklassifikation ging bisher mit einem erheblichen Sicherheitsrisiko für die Ausfallsicherheit der Windenergieanlage einher, welches mit der Erfindung vermieden wird. Die Erfindung vereint damit Vorteile hinsichtlich günstiger Betriebskosten mit erhöhter Sicherheit.

Vorzugsweise weist der Stellantrieb einen schaltbaren Widerstand an seinem Eingang auf. Das Vorsehen eines solchen Widerstands bedeutet einen vernachlässigbaren Aufwand.

Bevorzugt ist es, wenn der Stellantrieb einen Umrichter und einen Gleichstrommotor umfasst, wobei das Belastungsmodul dazu ausgebildet ist, den Gleichstrommotor mit einem vorgebbaren Strom gemäß der definierten Belastung zu beaufschlagen. Die Erfindung macht sich hierbei zu Nutze, dass bei modernen Windenergieanlagen der Stellantrieb der Pitcheinrichtungen in der Regel ohnehin einen Umrichter und einen Motor, meist ein Gleichstrommotor,

2

aufweist. Insoweit fällt kein Zusatzaufwand an. Indem der Umrichter mit dem von ihm versorgten Motor so geschaltet wird, dass er als Festlast fungiert, kann damit ohne Zusatzaufwand in Bezug auf Hardware eine feste und gewünschte hohe Belastung aufgebracht werden. Mit dem Umrichter wird eine Prüfung der Batterie auch bei hohem Strom ermöglicht. Damit kann sowohl ein schneller Test durchgeführt werden, wie auch ein Stress-Test, welcher eine hohe Aussagekraft in Bezug auf die Tauglichkeit der Batterie besitzt. Ein weiterer Vorteil der Verwendung des Umrichters liegt darin, dass die auf die Batterie aufzubringende Belastung nicht durch einen Widerstand und dessen Leistungsbelastbarkeit limitiert ist. Um gewünschtenfalls eine noch größere Belastung aufbringen zu können, ist zweckmäßigerweise eine Bremse des Stellantriebs betätigt, gegen welche der Stellantrieb arbeitet. Dies ermöglicht es, den Test der Batterie unabhängig von der Position der Rotorblätter durchzuführen. Damit ist es nicht notwendig, das Rotorblatt in eine Grenzposition zu bringen, in der es beispielsweise an einem Anschlag anliegt. Der Belastungstest kann damit universeller eingesetzt werden. Insbesondere kann der Test auch während des Betriebs der Windenergieanlage durchgeführt werden, und zwar während sich diese im Teillastbetrieb befindet. Zur weiteren Erhöhung der Belastung der Batterie kann auch vorgesehen sein, dass zusätzlich der Widerstand an den Eingang des Stellantriebs mit bestromt wird. Um eine Überlastung gerade bei großen Testströmen zu vermeiden, wird vorzugsweise eine Temperaturüberwachung an dem Umrichter und/oder dem Widerstand vorgesehen.

Gemäß einer bevorzugten Weiterbildung der Erfindung ist ein Entladesteuermodul vorgesehen, welches dazu ausgebildet ist, die an dem Stellantrieb wirkende Spannung zu Testbeginn auf ein vorbestimmbares Spannungsniveau zu verringern. In der Regel handelt es sich um das Batteriespannungsniveau, auf das der Zwischenkreis entladen wird. Es kann aber weitergehend auch die Batterie entladen werden. Das ist dann sinnvoll, wenn zur Gewährleistung einer ausreichenden Sicherheit die Energieversorgungseinheit so konzipiert sein soll, dass sie nicht nur bei idealer, vollgeladener Batterie eine Verstellung der Rotorblätter bewirken kann, sondern auch bei nur teilweise geladener Batterie.

Vorzugsweise wirkt das Belastungmodul weiter mit einem Trennschütz zusammen, welches die Batterie von einer Netzversorgung trennt. Mit dem Trennschütz wird erreicht, däss eine Aufladung der Batterie über die Netzversorgung während des Tests verhindert wird, und damit einer Gefahr der Verfälschung des Testergebnisses durch die Netzversorgung entgegengewirkt wird.

Außerdem ist vorzugsweise ein Überwachungsmodul vorgesehen, welches den Zustand, insbesondere Temperatur des Widerstands, die Position des Rotorblatts (bzw. die Funktion der Bremse) und/oder des Gleichstrommotors überwacht und erforderlichenfalls den Test abbricht. Damit wird der Gefahr entgegengewirkt, dass insbesondere beim Testen mit hohen Strömen eine Überlastung der zum Test verwendeten Komponenten eintritt. Dabei auftretende Schäden hätten nicht nur den Nachteil, dass sie zu Komponentenausfall führen, sondern würden sogar zu einer Stillsetzung der Windenergieanlage führen (was erhebliche Kosten bedeutet), da es sich hierbei um sicherheitskritische Komponenten handelt.

Mit Vorteil ist ein Lasterkennungsmodul vorgesehen, das einen Lastzustand der Windenergieanlage bestimmt und bei Überschreiten einer Schwelle das Belastungssteuermodul sperrt. Unter Sperren wird hierbei verstanden, dass das Belastungssteuermodul in einen solchen Zustand gebracht ist, dass es keine Tests der Batterie durchführt. Es hat sich gezeigt, dass die Erfindung zwar grundsätzlich ein Testen der Windenergieanlage im laufenden Betrieb erlaubt, jedoch dass dies nicht unter Volllast oder hoher Teillast erfolgen sollte, da in diesen Bereichen eine Pitchverstellung durch den Pitchmotor notwendig ist. Die zusätzlichen, durch den Test der Batterie aufgebrachten Lasten können bei stärkerem Wind dazu führen, dass die Pitcheinrichtung mit übermäßig hohen Verstellkräften belastet wird. Um die Gefahr von Beschädigungen oder Ausfällen auszuschließen, erkennt das Lasterkennungsmodul das Auftreten einer Situation mit hoher Last, und verhindert dabei das Ausführen des Batterietests oder unterbricht diesen, sofern während des Batterietests eine hohe Last beispielsweise anhand der Drehzahl, der Leistung und/oder der Windgeschwindigkeit erkannt wird.

Zweckmäßigerweise wirkt das Lasterkennungsmodul mit einem Zeitgeber zusammen, welcher in vorgebbaren Abständen einen Test bewirkt und Zeitabläufe beim Testen überwacht. Damit kann eine weitgehend automatisierte Überwachung der Windenergieanlage im autarken Betrieb folgen.

Das erfindungsgemäße Belastungssteuermodul kann vorzugsweise dazu weiter ausgebildet sein, bei betätigter Bremse das Rotorblatt auf Pitchänderung zu überwachen. Bewegt sich das Rotorblatt trotz betätigter Bremse bei der Durchführung des Belastungstests, so bedeutet dies einen Fehler der Bremse und ein entsprechendes Signal wird an die Betriebssteuerung der Windenergieanlage abgegeben. Dies kann auch gezielt erfolgen. So kann zur Prüfung des Zustands der Bremse zusätzlich eine Bremsenprüfeinheit vorgesehen sein, welche den Stellantrieb mit einem bestimmten Prüfmoment bestromt. Das Prüfmoment ist so gewählt, dass es kleiner ist als das von der Bremse aufbringbare Haltemoment. Rutscht die Bremse dennoch durch, so ist die Bremse schadhaft und es wird ein Fehlersignal ausgegeben.

Vorzugsweise ist weiter ein Monitormodul vorgesehen, welches die Funktionalität des Batteriewächters prüft. Damit kann eine Eigenkontrolle realisiert werden. Damit wird insbesondere die gefährliche Situation vermieden, dass an sich nicht mehr funktionsfähige Batterien durch ein fehlerhaft arbeitendes Belastungssteuermodul noch fälschlicherweise als "gurt" klassifiziert werden. Zweckmäßigerweise weist das Monitormodul dazu einen Detektor auf, der zu Testbeginn die Batteriespannung auf einen Einbruch hin überwacht und bei dessen Fehlen ein Fehlersignal ausgibt.

Auch bei guten Batterien kommt es auf Grund der hohen Last zu Beginn des Tests zu einem Spannungseinbruch. Bleibt dieser Einbruch aus, so bedeutet dies, dass entweder die Spannungsüberwachung fehlerhaft arbeitet oder dass die Batterie noch über das Netz versorgt wird. In beiden Fällen ist ein Testen nicht möglich, und es wird entsprechend ein Fehlersignal ausgegeben.

Eine erste Überwachungsmethode besteht darin, dass die Spannung des Akkumulators unter Last geprüft wird. Dazu wird die Pitch-einrichtung betätigt, wobei Strom aus dem Akkumulator entnommen wird, und der dabei auftretende Spannungseinbruch bestimmt wird. Bei einer zweiten, fortgeschrittenen Überwachungsmethode wird nicht nur die Höhe des Spannungseinbruchs überprüft, sonders auch der zeitliche Verlauf überwacht. Dazu ist ein Batteriewächter vorgesehen, der dazu ausgewählt ist, einen Einbruch der Spannung während der Belastung kurzzeitig zu tolerieren, und den Spannungsverlauf daraufhin zu überprüfen, ob sich die Spannung nach Ende der Belastung innerhalb einer definierten Zeit wieder erholt. Werden hierbei vordefinierte Grenzwerte nicht eingehalten, so wird der Akkumulator als nicht mehr tauglich klassifiziert. Ein Nachteil dieser Methoden ist die Abhängigkeit von externen Faktoren. So kann es sein, dass die Stromaufnahme des Stellantriebs erhöht ist wegen Schwergängigkeit des Getriebes wegen einer ungünstigen Windlast oder wegen sehr kalter Temperaturen. Eine dadurch bedingte erhöhte Stromaufnahme führt zu einem größeren und länger dauernden Spannungseinbruch, so dass an sich noch brauchbare Akkumulatoren unter dieser überhöhten Belastung als austauschreif erscheinen. Im Übrigen kann es auch auftreten, dass bei bestimmter Windlast die Belastung so weit reduziert ist, dass an sich verschlissene Akkumulatoren nur einen geringen Spannungseinbruch aufweisen und damit als weiter einsatzfähig klassifiziert werden.

Gemäß einer weiteren vorteilhaften Ausführungsform der Erfindung, die ggf. unabhängigen Schutz verdient, ist ein Prüfsteuermodul vorgesehen. Dieses ist dazu ausgebildet, eine wählbare Prüfcharakteristik auf den Stellantrieb aufzuschalten. Dazu weist das Prüfsteuermodul einen Speicher mit mehreren Prüfsteuercharakteristiken auf, aus welchen eine ausgewählt und zur Prüfung mittels des Belastungssteuermoduls verwendet wird. Vorzugsweise sind mindestens drei Prüfcharakteristiken als Profile in dem Speicher enthalten. Ein erstes Profil, welches eine Belastung mit einem festen Widerstand bildet, ein zweites Profil, welches eine Belastung mit einem Konstantstrom bildet und eine drittes Profil, welches eine Belastung mit einer konstanten Leistung bildet. Die Belastung mit einem Widerstand bildet den einfachsten Fall, der den geringsten Hardwareaufwand erfordert. Die Belastung mit konstanter Leistung bietet den Vorteil, dass sie am ehesten der Belastung im realen Betrieb entspricht. Die Belastung mit konstantem Strom bietet den Vorteil, dass sie die am besten auswertbaren Ergebnisse liefert, da die Spannungsänderungen der Batterie bei Belastung unmittelbar als Maß verwendet werden können. Der Stellantrieb wird hierbei derart angesteuert, dass ein konstanter Strom durch den Motor geführt ist. Hierbei wirkt der Stellantrieb mit seinem Umrichter wie ein Transformator für Gleichstrom, wobei das Übersetzungsverhältnis durch die Ansteuerung verändert werden kann. Dies geschieht in der Regel dadurch, dass das Prüfsteuermodul den Stellantrieb mit einem vorgebbaren Modulationsgrad steuert. Dieser kann entsprechend der jeweils gewünschten Belastung verändert werden. Der an sich feste Widerstand des eigentlichen Motors wird dadurch batterieseitig zu einem einstellbaren Widerstand. Dadurch werden bei minimalem zusätzlichen Hardwareaufwand zwei wesentliche Vorteile realisiert, nämlich dass zum einen die Belastung der Batterie variabel geändert und eingestellt werden kann und zum anderen Änderungen des Motorwiderstands, beispielsweise statisch durch Exemplarstreuungen oder dynamisch durch Widerstandserhöhung auf Grund von Erwärmung, leicht kompensiert werden können. Zweckmäßigerweise ist das Prüfsteuermodul dazu so ausgebildet, dass es tatsächliche Parameter des Motors erfasst und eine Kompensationseinheit aufweist, welche Veränderungen der Parameter von einem Normwert ausgleicht.

Bei größeren Windenergieanlagen werden häufig Doppelschlussmotoren als Stellantriebe eingesetzt, welche über eine Reihenschluss- und eine Nebenschlusswicklung verfügen. Es hat sich gezeigt, dass für die Belastungsprüfung der Betrieb als reiner Reihenschlussmotor günstiger ist. Zweckmäßigerweise wirkt das Prüfsteuermodul mit einem Erregungsschaltmodul zusammen, welches bei der Prüfung nur die Reihenschlusswicklung bestromt und die Nebenschlusswicklung trennt.

Um mit möglichst geringer Zusatzbelastung für die Komponenten des Stellantriebs auszukommen, ist vorzugsweise ein Richtungswahlmodul vorgesehen. Dieses ist dazu ausgebildet, im Betrieb der Windenergieanlage eine Belastungsrichtung des Rotorblatts zu bestimmen und derart auf das Prüfsteuermodul einzuwirken, dass der Stellantrieb das Blatt in Gegenrichtung betätigt. Damit wird die aus aerodynamischen Kräften rührende Vorbelastung des Blattes in günstiger Weise als zusätzliche Last benutzt, so dass insoweit der Stellantrieb und die Bremse davon entlastet sind.

Vorzugsweise ist eine Protokolleinheit vorgesehen, welche dazu ausgebildet ist, Daten und Statussignale zur Durchführung des Tests sowie Ergebnisse zu protokollieren. Sie ist mit Vorteil mit der Betriebssteuerung der Windenergieanlage und/oder einer Steuerung der Pitcheinrichtung verbunden. Es kann eine Bewertung und eine Weiterleitung vorgenommen werden, so dass im Fehlerfall eine entsprechende Fehlermeldung an eine übergeordnete Instanz (Parkmaster oder Netzbetreiber bzw. Wartungsunternehmen) übermittelt werden kann. Diese kann auf die Störung reagieren und eine Behebung veranlassen.

Die Erfindung bezieht sich auch auf eine Überwachungseinrichtung für eine Pitcheinrichtung für Windenergieanlagen mit einer Batterie und einem Stellantrieb, wobei die Überwachungseinrichtung einen Batteriewächter umfasst, wobei erfindungsgemäß ein Belastungssteuermodul vorgesehen ist, welches den Stellantrieb zwischen einem Betriebsmodus und einem Prüfmodus umschaltet, wobei im Prüfmodus der Stellantrieb eine vorwählbare definierte Belastung bildet.

Außerdem bezieht sich die Erfindung auf ein Verfahren zum Überwachen einer Pitcheinrichtung von Windenergieanlagen, wobei die Pitcheinrichtung eine Batterie und einen Stellantrieb aufweist, und beim Testen eine Batteriespannung im Lastfall überwacht wird, und erfindungsgemäß der Stellantrieb zwischen einem Betriebsmodus und einem Prüfmodus umschaltet, wobei im Prüfmodus der Stellantrieb zur Erzeugung einer definierten Last verwendet wird.

Zur näheren Erläuterung wird auf obige Ausführungen verwiesen.

Die Erfindung wird nachfolgend unter Bezugnahme auf die beigefügte Zeichnung erläutert, in der ein vorteilhaftes Ausführungsbeispiel der Erfindung dargestellt ist. Es zeigen:

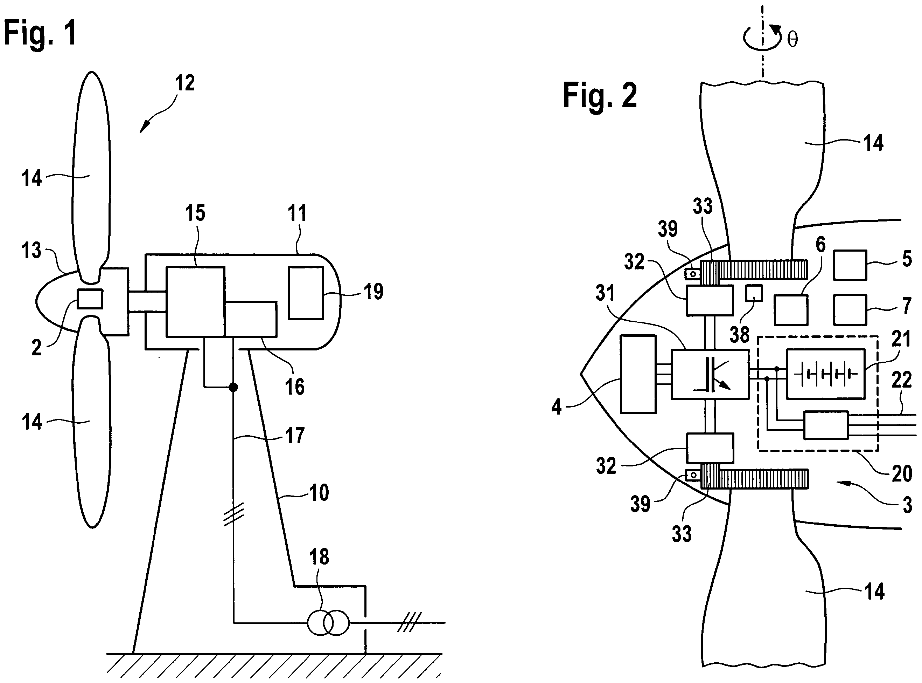

Fig. 1       eine Windenergieanlage gemäß einem Ausführungsbeispiel der Erfindung in einer schematischen Übersicht;

Fig. 2       eine vergrößerte Darstellung der Nabe mit einer Pitch-einrichtung der in Fig. 1 dargestellten Windenergieanlage;

Fig. 3       ein Funktionsdiagramm für eine Regelung eines Stellantriebs der Pitcheinrichtung;

Fig. 4       ein Blockdiagramm für die elektrische Schaltung der Pitcheinrichtung mit Überwachungeinheit; und

Fig. 5a-d    Diagramme zum Verlauf von Spannungen und Strömen.

Eine Windenergieanlage gemäß einem Ausführungsbeispiel der Erfindung umfasst eine auf einem Turm 10 in Azimuthrichtung verschwenkbare Gondel 11, an deren einer Stirnseite ein Windrotor 12 drehbar angeordnet ist. Der Windrotor 12 umfasst eine Nabe 13 und ein oder mehrere Rotorblätter 14. Er treibt über eine (nicht dargestellte) Rotorwelle einen Generator 15 an. Dieser wandelt die vom Windrotor 12 aus dem Wind erzeugte mechanische Leistung in elektrische Leistung um. Bei dem Generator 15 handelt es sich um eine doppelt gespeiste Asynchronmaschine (es können aber auch andere Generatorbauarten vorgesehen sein). Mit diesem verbunden ist ein Umrichter 16. An den Generator 15 und den Umrichter 16 ist eine Leitung 17 angeschlossen, welche die erzeugte elektrische Leistung durch den Turm 10 zu einem am dortigen Fuß angeordneten Mittelspannungstransformator 18 zur Weiterleitung in ein Netz (nicht dargestellt) transportiert. Ferner ist in der Gondel 11 eine Betriebsteuerung 19 angeordnet, welche den Betrieb der gesamten Windenergieanlage überwacht.

Zur Verstellung des Anstellwinkels der Rotorblätter 14 ist in der Nabe 13 eine in ihrer Gesamtheit mit der Bezugsziffer 2 bezeichnete Pitcheinrichtung vorgesehen. Sie umfasst eine Energieversorgungseinheit 20, welche eine Batterie 21 sowie einen Anschluss an eine anlageninterne Netzversorgung 22 umfasst. Sie versorgt mindestens einen Stellantrieb 3, welcher im Wesentlichen einen Zwischenkreis 34, einen Widerstand 30, einen Umrichter 31 sowie einen Gleichstrommotor 32 als Aktuator umfasst. Letzterer bewirkt über einen als Stirnradgetriebe 33 ausgebildeten Zahnradsatz eine Verdrehung der Rotorblätter um ihre Längsachse, um so den Anstellwinkel $\theta$ zu verändern. Dieser und die Verstellgeschwindigkeit n sind von einem Sensor 38 am Zahnkranz erfasst. Der Zahnradsatz 33 ist vorzugsweise so ausgeführt, dass er selbsthemmend ist. Darunter wird verstanden, dass unter dem Einfluss aerodynamischer Lasten das Rotorblatt 14 es nicht (oder nur wenig) vermag, den Gleichstrommotor 32 über das Stirnradgetriebe 33 zu verdrehen. Es sei angemerkt, dass auch andere Getriebebauarten vorgesehen sein können, beispielsweise ein Schneckengetriebe zur Erhöhung der Selbsthemmung. Um unter allen Betriebszuständen eine sichere Positionierung der Rotorblätter 14 in Bezug auf ihren Anstellwinkel $\theta$ zu erreichen, ist ferner noch eine Bremse 39 vorgesehen. Sie kann in an sich bekannter Weise in Bremssattelbauart oder als elektromagnetische Bremse ausgeführt sein.

Zur Steuerung der Pitcheinrichtung 2 ist eine Kontrolleinheit 4 vorgesehen. Sie ist über (nicht dargestellte) Signalisierungsleitungen mit den anderen Komponenten der Pitcheinrichtung verbunden und empfängt ihrerseits ihre Führungssignale über (gleichfalls nicht dargestellte) Signalisierungsleitungen von der Betriebssteuerung 19 und übermittelt umgekehrt Zustandssignale und Fehlermeldungen an diese.

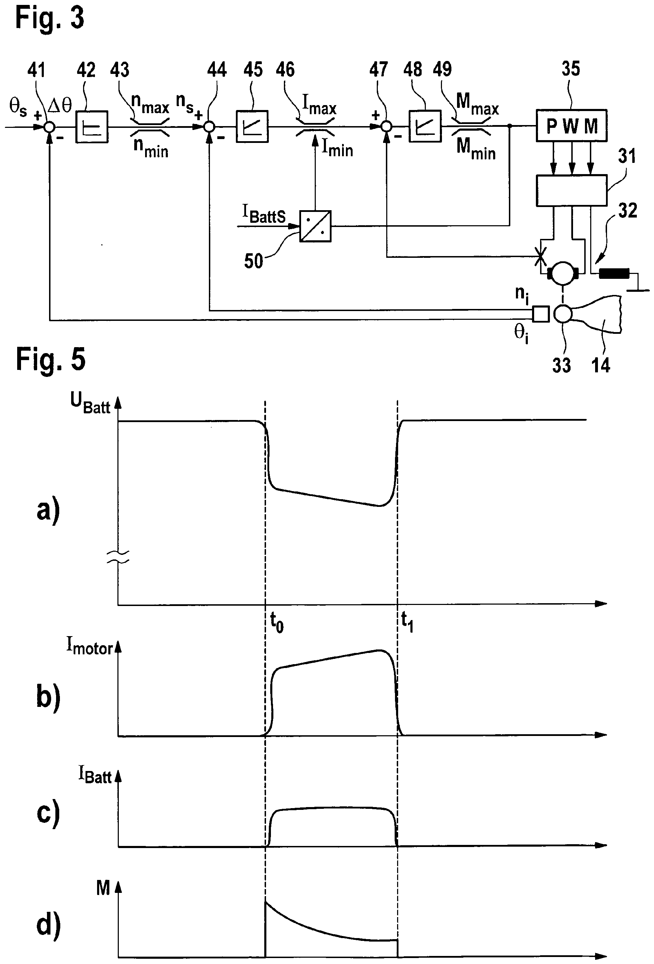

Die Funktionsweise zur Verstellung des Anstellwinkels sei in Bezug auf Fig. 3 erläutert. Ein Sollwert für den Anstellwinkel $\theta$ ist an einen Sollwerteingang der Regelung für den Anstellwinkel angelegt. Genauer gesagt ist er an den positiven Eingang eines Summierglieds 41 angelegt. An dessen negativen Eingang ist ein vom Sensor 38 bestimmter Messwert für den tatsächlichen Anstellwinkel angelegt. Daraus wird eine Differenz gebildet und an einen Lage-, Winkel- oder Positionsregler 42 angelegt. Dieser bestimmt daraus eine Verstellgeschwindigkeit n, welche begrenzt wird mittels eines Grenzwertglieds 43. Von dieser Sollgeschwindigkeit wird der wiederum von dem Sensor 38 bestimmte Wert für die Geschwindigkeit abgezogen an der Summierstelle 44, und die sich dabei ergebende Differenz an einen Drehzahlregler 45 angelegt. Dieser bestimmt daraus ein Strommaß für das vom Motor 32 geforderte Moment. Das Strommaß wird an einen Begrenzer 46 angeschlossen. Das so begrenzte Strommaß wird als Sollwert an eine Summierstelle 47 angelegt, an deren negativen Eingang ein Maß für den tatsächlichen Motorstrom angelegt ist. Die sich so ergebende Differenz ist an den Eingang eines Stromreglers 48 angelegt, der daraus ein Signal für die Länge der Einschaltpulse der aktiven Schalter des Umrichters 31 bestimmt. Dieses Signal wird wiederum beschränkt durch Maximum- und Minimumbegrenzer, und wird im Anschluss an den Steuereingang des Pulsbreitenmodulators 35 angelegt. Dieser kontrolliert das Schalten der aktiven Elemente des Umrichters 31. Bei dieser Struktur entsteht das Problem, dass bei festgebremstem Motor 32 eine Veränderung des Sollwerts für die Winkelsituation dazu führt, dass die entsprechenden Sollwerte für Drehzahl und Motorstrom in die Begrenzung laufen. Um dies vorwegzunehmen, kann die Stromregelung des Drehzahlreglers 45 zusätzlich reduziert werden durch ein Rückführsignal, und zwar auf obere und untere Grenzen für den Motorstrom. Dies kann im Rahmen einer Vorsteuerung 50 erfolgen, wie sie in Fig. 3 abgebildet ist. Die Vorsteuerung 50 ist dazu ausgebildet, für einen gewünschten Batteriestrom einen entsprechenden Motorstromsollwert zu erzeugen. Damit wird vermieden, dass die Regler 42, 45 und 48 beim Test in die Sättigung laufen.

An die Kontrolleinheit 4 ist ein Batteriewächter 40 angeschlossen. Dieser ist dazu ausgebildet, den Ladezustand der Batterie 21 zu überwachen. Die Batterie 21 kann grundsätzlich während des normalen Betriebes über die anlageninterne Netzversorgung 22 geladen werden, so dass sie im Fall eines Netzausfalls eine ausreichende Energieversorgung für die Pitcheinrichtung 2 gewährleisten kann. Diese ist so bemessen, dass die Rotorblätter 14 unter allen Bedingungen sicher in die neutrale Fahnenposition verfahren werden können. Es versteht sich, dass die Batterien 21 dazu eine ausreichende Kapazität aufweisen müssen und weder defekt noch durch Verschleiß soviel Kapazität verloren haben dürfen, dass die von ihnen gespeicherte Ladung nicht mehr zum Verfahren der Rotorblätter 14 in die sichere Fahnenposition ausreicht. Sie werden mittels des Batteriewächters 40 in regelmäßigen Abständen auf ihre Funktionsfähigkeit geprüft.

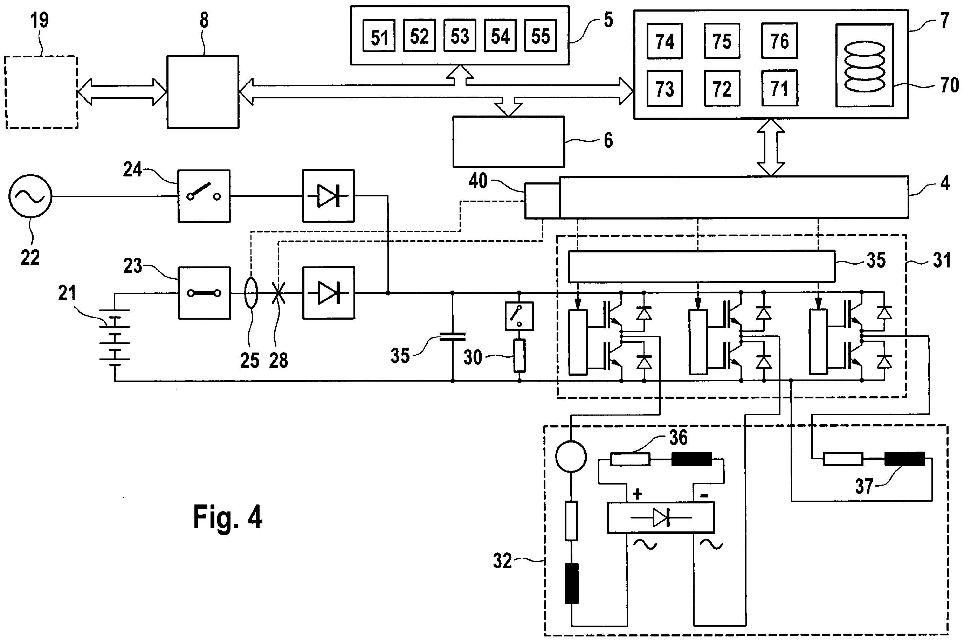

Zunächst sei der Aufbau des Stellantriebs 3 mit seinem Zusammenwirken mit der Batterie 21 anhand der Fig. 4 näher erläutert. Der Umrichter 31 versorgt den Gleichstrommotor 32, der als ein Doppelschlussmotor mit einer Reihenschlusswicklung 36 und einer Nebenschlusswicklung 37 ausgeführt ist. Der Umrichter 31 wiederum wird versorgt von einem Zwischenkreis 34 mit einem Glättungskondensator 35. Der Zwischenkreis 34 wird auf zwei verschiedene Weisen mit elektrischer Energie versorgt. Zum einen steht eine Netzversorgung 22 zur Verfügung, die über ein Trennschütz 24 mit einer Eingangsseite des Zwischenkreises verbunden werden kann. Zum anderen ist eine Batterie 21 vorgesehen, die über ein Batterieschütz 23 an die Eingangsseite des Zwischenkreises 34 angeschlossen ist. Die Netzversorgung 22 dient einerseits zur direkten Versorgung des Umrichters 31 mit dem Gleichstrommotor 32, aber auch zum Aufladen der Batterie 21. Die Batterie 21 übernimmt, wie bereits erläutert, im Fall eines Netzausfalls die Versorgung, so dass über den Umrichter 31 der Gleichstrommotor 32 so angesteuert werden kann, um die Rotorblätter in eine sichere Position zu verfahren. An dem Zwischenkreis 34 ist ein Spannungssensor 25 zwischen dem Batterieschütz 23 und dem Umrichter 31 angeordnet. Weiter ist optional ein schaltbarer Festwiderstand 30 parallel zum Eingang des Umrichters 31 an den Zwischenkreis 34 angeschlossen. Mit ihm kann der Zwischenkreis 34 und damit die Batterie 21 belastet werden. Die Schütze 23, 24 sowie der Umrichter 31 werden von der Kontrolleinheit betätigt.

Die Kontrolleinheit 4 wirkt mit einem Belastungssteuermodul 5, einem Lasterkennungsmodul 6 sowie einem Prüfsteuermodul 7 zusammen. Das Belastungssteuermodul 5 umfasst ein Entladesteuermodul 51, ein Überwachungsmodul 52, einen Zeitgeber 53, ein Monitormodul 54 und einen Detektor 55. Das Prüfsteuermodul 7 umfasst einen Speicher 70, einen Modulationsgradgeber 71 sowie eine Messeinheit 72 zur Bestimmung tatsächlicher Parameter des Gleichstrommotors 32, eine Kompensationseinheit 73, eine Bremsenprüfeinheit 74, ein Richtungswahlmodul 75 und ein Erregungsschaltmodul 76. In dem Speicher 70 sind mehrere Profile für unterschiedliche Belastungen enthalten. Im Prüfmodus kann eines der Profile ausgewählt und der Umrichter 31 entsprechend betrieben werden, so dass der festgebremste Gleichstrommotor 32 die Belastung gemäß dem gewählten Profil erzeugt. Hierbei betätigt das Prüfsteuermodul 7 das Erregungsschaltmodul 76, welches dazu ausgebildet ist, im Prüfmodus die Nebenschlusswicklung 37 abzutrennen. Das bedeutet, die Erregung wird allein durch die Reihenschlusswicklung 36 im Prüfmodus bewirkt. Das Drehmoment des Gleichstrommotors 32 wird damit unabhängig von der Batteriespannung, so dass ein besseres Verhalten des Gleichstrommotors 32 im Prüfmodus erreicht werden kann. Der Umrichter 31 wirkt hier wie ein Transformator für Gleichstrom, wobei das Übersetzungsverhältnis durch die Ansteuerung des Umrichters 31 mittels des Modulationsgradgebers 71 verändert werden kann. Der an sich feste Widerstand des Gleichstrommotors 32 stellt sich so an dem Zwischenkreis 34 und damit für die Batterie 21 als variabler (Last-)Widerstand dar.

Angefordert wird ein Test der Batterie 21 meist durch die Betriebssteuerung 19. Es kann aber auch vorgesehen sein, dass die Kontrolleinheit 4 autark den Test veranlasst oder eine Testdurchführung bei der Steuerung anfordert, beispielsweise über den Zeitgeber 53. So kann der Test in regelmäßigen zeitlichen Abständen durchgeführt werden, beispielsweise wöchentlich, in Abhängigkeit der Belastung der Batterie, beispielsweise nach jedem zehnten Ladevorgang, oder in besonderen Situationen, wie beispielsweise bei Spannungswiederkehr nach Netzausfall oder auf manueller Anforderung durch Servicepersonal.

In einem ersten Schritt des Tests werden definierte Ausgangsbedingungen geschaffen. Dazu steuert das Belastungsteuermodul 5 das Entladesteuermodul 51 derart an, dass über den Festwiderstand 30 der Zwischenkreis 34 auf ein vorher definiertes Spannungsniveau, in der Regel das Batteriespannungsniveau, entladen wird. Die Höhe der Spannung wird über den Spannungssensor 25 und den Batteriewächter 40 bestimmt. Damit werden definierte Bedingungen für den Test geschaffen, welche eine Reproduzierbarkeit sicherstellen. Durch das Prüfsteuermodul 7 wird bestimmt, welche Art von Test ausgeführt wird.

Dies sei zur Anschauung am einfachen, nicht erfindungsgemäßen Fall erläutert, bei dem eine definierte Belastung durch den Festwiderstand 30 erfolgt. Für den Test wird der Festwiderstand 30 betätigt. Es fließt dann ein Strom aus der Batterie 21 in den Zwischenkreis 34 und in den Widerstand 30. Mittels des Spannungssensors 25 misst der Batteriewächter 40 die Batteriespannung und prüft auf einen Spannungseinbruch. Wird hierbei eine vorher festlegbare Spannungsschwelle unterschritten, so erkennt der Batteriewächter 40 einen Fehler. Von der Kontrolleinheit 4 wird ein entsprechendes Fehlersignal an die Betriebssteuerung 19 zurückgegeben.

Die Belastung mit einem passiven Widerstand kann auch durch den Umrichter 31 in Verbindung mit dem Motor 32 simuliert werden, so dass kein gesonderter Festwiderstand 30 benötigt wird. Dazu wird aus dem Speicher 70 das Profil für den festen Widerstand geladen. Das Prüfsteuermodul 7 steuert den Umrichter 31 entsprechend diesem Profil an, so dass sich der Gleichstrommotor 32 an dem Zwischenkreis 34 und damit für die Batterie 21 wie ein Festwiderstand verhält.

Es ist auch möglich, zur Erhöhung der Batteriebelastung beim Test den Gleichstrommotor 32 mit dem Profil "Festwiderstand" zusammen mit dem Festwiderstand 30 als Last zu verwenden. Damit kann ein sehr hoher Belastungsstrom eingestellt werden, ohne die dafür verwendeten Komponenten zu überlasten. Insbesondere weist diese Anordnung ein beträchtlich größeres thermisches Energieaufnahmevermögen als ein Festwiderstand auf. Das Prüfsteuermodul 7 steuert, wie vorstehend beschrieben, den Umrichter 31 so an, dass dieser sich wie ein Festwiderstand verhält. Dadurch erfolgt eine gleichartige Belastung, die auf die vorherbeschriebene Weise einfach mittels des Spannungssensors 25 und des Batteriewächters 40 ausgewertet werden kann.

Um unerwünschtes Verdrehen des Rotorblatts 14 beim Bestromen des Gleichstrommotors 32 zu verhindern, wird die Bremse 39 von dem Belastungssteuermodul 5 betätigt. Damit wird sichergestellt, dass der Anstellwinkel $\theta$ erhalten bleibt. Zweckmäßigerweise wird hierbei der Anstellwinkel $\theta$ mittels (nicht dargestellten) Sensoren überwacht. Erfolgt trotz betätigter Bremse 39 eine Veränderung des Blattwinkels, so ist dies ein Signal dafür, dass die Bremse 39 defekt ist. Dies wird von der Bremsprüfeinheit 74 überwacht, welche im Fehlerfall ein entsprechendes Fehlersignal an die Kontrolleinheit 4 und diese an die Betriebssteuerung 19 übermittelt. Die hierbei auftretenden Verstellmomente können beträchtlich sein. Insgesamt stellt der Test eine erhebliche Belastung dar. Um eine sichere Aussage über den Zustand der Batterie 21 machen zu können, sollte der entnommene Strom für eine bestimmte Zeitdauer über einem bestimmten Strom liegen. Die Werte sind nicht konstant und hängen vom jeweiligen Betriebszustand ab. Als Größenordnung kann für eine 2MW-Windenergieanlage eine Zeitdauer von etwa mind. 7 Sekunden und mindestens 50 Ampere angegeben werden; damit würden etwa 0,1 Ah entnommen werden. Zweckmäßigerweise werden mittels (nicht dargestellter) Temperatursensoren die Temperatur sowohl des schaltbaren Widerstands 30 als auch am Gleichstrommotor 32 überwacht, um eine Überhitzung zu vermeiden. Dazu ist das Überwachungsmodul 52 vorgesehen.

Weiter wird mit dem Monitormodul 55 geprüft, ob der Batteriewächter 40 einsatzbereit ist. Es wird eine solche Last aufgebracht oder die Batterie soweit entladen, dass beim Aufbringen der Last ein solcher Spannungseinbruch auftritt, auf den der Batteriewächter anspricht. Spricht er dennoch nicht an, so ist es wahrscheinlich, dass der Batteriewächter 40 nicht korrekt arbeitet. Wird ein Fehler festgestellt, beispielsweise ein Hängen eines Schaltkontakts, so dass stets "gurt" angezeigt wird, so wird der Test beendet.

Es können auch andere Profile in dem Speicher 70 enthalten sein. Bewährt haben sich ebenfalls Profile für Belastung mit konstantem Strom und Belastung mit konstanter Leistung. Letzteres bietet den Vorteil, dass sie die Belastung der Batterie 21 im realen Betrieb beim Verfahren der Rotorblätter 14 in die Fahnenposition zumindest annähernd approximiert. Das Profil für Belastung mit konstantem Strom bietet hingegen den Vorteil, dass es eine günstigere Auswertung durch das Prüfsteuermodul 5 ermöglicht. Dies sei nachfolgend näher erläutert.

Für den Prüfmodus mit konstantem Strom muss der Batteriestrom gemessen und mittels einer Regelung konstant gehalten werden. Dazu muss der Stromfluss bestimmt werden. Zu diesem Zweck kann ein Stromsensor 28 am Zwischenkreis 34 angeordnet sein. Zur Vermeidung des zusätzlichen Stromsensors 28 kann der Batteriestrom mittels eines ersten Schätzers aus anderen, vorhandenen Größen bestimmt werden. Dazu benutzt man die Kenntnis, dass die Leistungsbilanz über Batterie 21 und Motor 32 im Prüfmodus, wenn das Trennschütz 24 zur Netzversorgung 22 geöffnet ist, ausgeglichen sein muss. Das Produkt aus Batteriespannung und -strom muss also gleich sein zu dem Produkt aus Motorspannung und -strom. Somit ist der die Batterie belastende Strom antiproportional zu den jeweiligen Spannungen, also

$$Ibatt = Imotor \ x \ Umotor \ / \ Ubatt.$$

Der Wert für die Batteriespannung ist in der Kontrolleinheit 4 ohnehin vorhanden, und der Wert für die Motorspannung Umotor wird vom Umrichter 31 bestimmt, und zwar abhängig von der Ansteuerung seiner aktiven Schaltelemente. Das Maß für die Ansteuerung ist der Modulationsgrad M. Technisch gesehen handelt es sich hierbei um das Ausgangssignal eines Pulsbreitenmodulators 35, der den Umrichter 31 ansteuert. Der Modulationsgrad M ist als Parameter der Umrichtersteuerung ohnehin verfügbar. Die Bestimmung der Batteriestroms vereinfacht sich daher zu

$$Ibatt = Imotor \times M.$$

Es sei angemerkt, dass definitionsgemäß M und Imotor immer das gleiche Vorzeichen aufweisen, so dass sich unabhängig von der Momentenrichtung des Gleichstrommotors 32 stets ein positiver Wert für den Batteriestrom ergibt. Die Drehrichtung ist also im Prüfmodus an sich beliebig. Um die Belastung für die Bremse 39 gering zu halten, bestimmt das Richtungswahlmodul 75 das insgesamt auf die Bremse 39 wirkende Moment unter Berücksichtigung der anderen, insbesondere aerodynamischen, auf das Rotorblatt 14 wirkenden Lasten. Es ermittelt, bei welcher Drehrichtung die Bremse 39 geringer beansprucht wird (weil die aerodynamische Last dem Drehmoment des Gleichstrommotors 32 entgegenwirkt) und wählt diese Drehrichtung aus.

Die Messeinheit 72 ist dazu ausgebildet, aus den Werten für die Motorspannung und -strom den wirksamen Widerstand des Gleichstrommotors 32 zu bestimmen. Sie verwendet dazu die Beziehung

$$Rmotor = Umotor / Imotor.$$

Treten schlagartige und/oder gravierende Änderungen auf, so deutet dies auf Fehler in Gestalt von Kontaktfehlern, Unterbrechung, Erd- oder Kurzschlüssen hin. Weiter kann über den Widerstandswert auch auf die Erwärmung des Gleichstrommotors 32 geschlossen werden, und bei Überschreiten bestimmter Grenzen zusammen mit dem Überwachungsmodul der Prüfmodus verlassen und damit der Test beendet werden. Die Gefahr einer Überlastung der Komponenten durch den Test ist damit minimiert. Dadurch können die Tests nicht nur im Stillstand der Windenergieanlage, sondern auch im Betrieb, jedenfalls bei Teillast, durchgeführt werden.

Die Wirkung der Erfindung sei anhand von Fig. 5 erläutert. Der Verlauf der Batteriespannung ist in Fig. 5 a) skizziert. Zum Zeitpunkt t0 beginnt der Test und es wird eine Last auf die zu prüfende Batterie aufgelegt. Man erkennt, dass die Spannung erst schlagartig und danach recht flach abfällt, bis zum Ende der Testbelastung zum Zeitpunkt T1. Der entsprechende Motorstrom Imotor ist in Fig. 5 b) dargestellt. Man erkennt, dass der Strom umso höher wird, je weiter die Batteriespannung einbricht. Wegen der Transformatorwirkung des Umrichters 31 unterscheidet sich der Strom Ibatt aus der Batterie 21 deutlich. So weist der Batteriestrom gemäß Fig. 5 c) keinen so ausgeprägten Anstieg bei nachlassender Spannung auf. Der Grund hierfür ist, dass zum Ausgleich der Modulationsgrad M verändert wird, wie in Fig. 5 d) dargestellt.

Die Bremsenprüfeinheit 74 ist dazu ausgebildet, die Bremse 39 zu überprüfen. Dazu wird wie oben beschrieben der Gleichstrommotor 32 als Last betrieben, und das von ihm erzeugte Drehmoment als Prüfmoment verwendet. Die Bremsenprüfeinheit 74 steigert das Drehmoment auf einen solchen Wert, der noch unterhalb oder höchstens gleich dem Haltemoment der Bremse 39 ist. Sie darf dann nicht durchrutschen. Tritt dies dennoch auf, so wird eine Fehlermeldung generiert und an die Betriebssteuerung 19 ausgegeben. Um den Einfluss des Rotorblatts 14 und der darauf wirkenden Lasten gering zu halten, wird das Richtungswahlmodul 77 entsprechend verwendet. Es kann auch vorgesehen sein, in zeitlich schneller Folge je eine Messung pro Drehrichtung durchzuführen, und basierend hierauf zumindest eine qualitative Gut/Schlecht-Bewertung vorzunehmen.

Die auf vorstehend beschriebene Weise bestimmten Parameter können der Kompensationseinheit 73 zugeführt sein. Diese ist dazu ausgebildet, Veränderungen in den Parametern zu ermitteln und entsprechende Kompensationssignale auszugeben. So kann der Motorwiderstand überwacht werden und bei einer Erhöhung ein Korrektursignal zum Modulationsgrad M ausgegeben werden, so dass die aus der Widerstandserhöhung resultierende Verringerung des Motorstroms kompensiert wird. Auf entsprechende Weise können auch Unterschiede aufgrund von Exemplarstreuungen erkannt und ausgeglichen werden. Die Qualität der Tests kann dadurch weiter erhöht werden, was zu einer höheren Betriebssicherheit der Windenergieanlagen führt.

Weiter ist eine Protokolleinheit 8 vorgesehen. Sie ist an der Pitchsteuerung 2 vorgesehen. Sie ist dazu ausgebildet, Statussignale und Messwerte von dem Prüfsteuermodul und dem Monitormodul zu erhalten und abzuspeichern. Weiter kann es eine Bewertung durchführen und erforderlichenfalls entsprechende Fehlersignale an eine übergeordnete Instanz, wie die Betriebssteuerung, übermitteln.

**Patentansprüche**

1.  Überwachungseinrichtung für eine Pitcheinrichtung (2) für Windenergieanlagen mit einer Batterie (21) und einem Stellantrieb (3) mit einem Motor, **dadurch gekennzeichnet, dass** ein Belastungssteuermodul (5) vorgesehen ist, welches den Stellantrieb (3) zwischen einem Betriebsmodus und einem Prüfmodus umschaltet, wobei im Prüfmodus der Stellantrieb (3) mit seinem Motor eine vorwählbare definierte Last für die Batterie (21) bildet.

2.  Windenergieanlage mit einem Rotor (12), einem davon angetriebenen Generator (15) zur Erzeugung elektrischer Energie, wobei der Rotor (12) mindestens ein mittels einer Pitcheinrichtung (2) verstellbares Blatt (14) aufweist, und die Pitcheinrichtung (2) eine Energieversorgungseinheit mit einer Batterie (21) und einem Stellantrieb (3) mit einem Motor und weiter eine Kontrolleinheit (4) umfasst, **dadurch gekennzeichnet, dass** eine Überwachungseinrichtung gemäß Anspruch 1 vorgesehen ist.

3.  Windenergieanlage nach Anspruch 2, **dadurch gekennzeichnet, dass**
    der Stellantrieb (3) einen schaltbaren Widerstand (30) an seinem Eingang aufweist und der Widerstand als zusätzliche Festlast fungiert.

4.  Windenergieanlage nach Anspruch 2 oder 3, **dadurch gekennzeichnet, dass**
    der Stellantrieb (3) einen Umrichter (31) und einen Gleichstrommotor (32) umfasst, und das Belastungssteuermodul (5) derart ausgebildet ist, den Gleichstrommotor (32) mit einem vorgebbaren Strom zu beaufschlagen, welcher der definierten Belastung entspricht.

5.  Windenergieanlage nach Anspruch 4, **dadurch gekennzeichnet, dass**
    eine Bremse (39) betätigt ist, gegen die der Stellantrieb (3) arbeitet, und insbesondere das Belastungssteuermodul (5) bei betätigter Bremse (39) das Blatt (14) auf Pitchänderung überwacht und ein Fehlersignal ausgibt.

6.  Windenergieanlage nach einem der Ansprüche 2 bis 5, **dadurch gekennzeichnet, dass**
    ein Entladesteuermodul (51) vorgesehen ist, welches die an dem Stellantrieb (3) wirkende Spannung zu Testbeginn auf ein vorbestimmtes Spannungsniveau absenkt.

7.  Windenergieanlage nach einem der Ansprüche 2 bis 6, **dadurch gekennzeichnet, dass**
    ein Lasterkennungsmodul (6) vorgesehen ist, das ein Lastzustand der Windenergieanlage bestimmt und bei Überschreiten einer Schwelle das Belastungssteuermodul (5) sperrt.

8.  Windenergieanlage nach einem der Ansprüche 2 bis 7, **dadurch gekennzeichnet, dass**
    ein Prüfsteuermodul (7) vorgesehen ist, welches eine wählbare Prüfcharakteristik auf den Stellantrieb (3) aufschaltet.

9.  Windenergieanlage nach Anspruch 8, **dadurch gekennzeichnet, dass**
    ein Speicher (70) vorgesehen ist, in welchen Profile eingespeichert sind, vorzugsweise für einen passiven Widerstand, einen Konstantstrom und eine Konstantleistung, und/oder
    das Prüfsteuermodul (7) einen Modulationsgradgeber (35) aufweist, der dazu ausgebildet ist, den vom Stellantrieb (3) abgegebenen Strom so einzustellen, dass sich der gewünschte Modulationsgrad einstellt, und/oder
    das Prüfsteuermodul (7) eine Messeinheit (72) zum Erfassen tatsächlicher Parameter des Gleichstrommotors (72) und eine Kompensationseinheit (73) aufweist, welche Veränderungen der Parameter von einem Normwert ausgleicht, und/oder
    das Prüfsteuermodul (7) mit einem Erregungsschaltmodul (76) zusammenwirkt, welches nur eine Reihenschlusswicklung (36) bestromt und eine Nebenschlusswicklung (37) trennt, und/oder
    das Prüfsteuermodul (7) ein Richtungswahlmodul (75) aufweist, dass im Betrieb der Windenergieanlage eine Lastrichtung des Blattes (14) bestimmt und so auf das Prüfsteuermodul einwirkt, dass der Stellantrieb (3) das Blatt (14) in Gegenrichtung betätigt.

10. Windenergieanlage nach Anspruch 8, **dadurch gekennzeichnet, dass**
    das Prüfsteuermodul (5) eine Bremsenprüfeinheit (74) aufweist, die mittels des Stellantriebs (3) ein bestimmtes Prüfmoment erzeugt.

11. Windenergieanlage nach Anspruch 10, **dadurch gekennzeichnet, dass**
    die Bremsenprüfeinheit (74) eine bidirektionale Prüfung durchführt durch Betätigen des Gleichstrommotors (32) in beide Drehmomentrichtungen gegen die Bremse, und wobei mittels eines Klassifikators eine Gut-/Schlechterkennung durchgeführt wird.

12. Windenergieanlage nach einem der Ansprüche 2 bis 11, **dadurch gekennzeichnet, dass** zusätzlich noch mindestens eine der folgenden Vorrichtungen vorgesehen ist:

ein Entladesteuermodul (51), welches die an dem Stellantrieb (3) wirkende Spannung zu Testbeginn auf ein vorbestimmtes Spannungsniveau absenkt;
ein Batteriewächter (40), welcher die Batterie insbesondere hinsichtlich ihres Spannungszustands überwacht;
ein Überwachungsmodul (52), welches den Zustand, insbesondere die Temperatur des Widerstands (30) und/oder des Gleichstrommotors (32) überwacht;
einen Zeitgeber (53) im Belastungssteuermodul (5), welcher in vorgebbaren Abständen einen Test bewirkt und Zeitabläufe beim Testen überwacht;
ein Lasterkennungsmodul (6), das einen Lastzustand der Windenergieanlage bestimmt und bei Überschreiten einer Schwelle das Belastungssteuermodul (5)sperrt;
ein Monitormodul (54) für den Batteriewächter (40), welcher dessen Funktionalität überwacht.

13. Verfahren zum Überwachen einer Pitcheinrichtung von Windenergieanlagen, wobei die Pitcheinrichtung (2) eine Batterie (21) und einen Stellantrieb (3) aufweist, und beim Testen eine Batteriespannung im Lastfall überwacht wird, **dadurch gekennzeichnet, dass** der Stellantrieb (3) zwischen einem Betriebsmodus und einem Prüfmodus umschaltet, wobei im Prüfmodus der Stellantrieb unter einer definierten Last für die Batterie (21) verwendet wird.

14. Verfahren nach Anspruch 13, **gekennzeichnet durch** Verwenden einer Kontrolleinheit nach einem der Ansprüche 2 bis 12.

**Claims**

1. Monitoring device for a pitch device (2) for wind energy installations having a battery (21) and an actuating drive (3) with a motor, **characterized in that** a load control module (5) is provided, which switches the actuating drive (3) between an operating mode and a test mode, wherein, in the test mode, the actuating drive (3) with its motor forms a preselectable defined load for the battery (21).

2. Wind energy installation having a rotor (12), a generator (15) which is driven by the rotor (12) for production of electrical energy, wherein the rotor (12) has at least one blade (14) which can be varied by means of a pitch device (2), and the pitch device (2) has a power supply unit with a battery (21) and an actuating drive (3) with a motor and, furthermore, a monitoring unit (4), **characterized in that** a monitoring device according to Claim 1 is provided.

3. Wind energy installation according to Claim 2,
**characterized in that**
the actuating drive (3) has a switchable resistance (30) at its input, and the resistance acts as an additional fixed load.

4. Wind energy installation according to Claim 2 or 3,
**characterized in that**
the actuating drive (3) comprises a converter (31) and a direct current motor (32), and the load control module (5) is designed to apply a predeterminable current, which corresponds to the defined load, to the direct current motor (32).

5. Wind energy installation according to Claim 4,
**characterized in that**
a brake (39) is operated, against which the actuating drive (3) acts, and in particular, when the brake (39) is operated, the load control module (5) monitors the blade (14) for a pitch change, and outputs a fault signal.

6. Wind energy installation according to one of the Claims 2 to 5,
**characterized in that**
a discharge control module (51) is provided, which reduces the voltage acting on the actuating drive (3) to a predetermined voltage level at the test start.

7. Wind energy installation according to one of the Claims 2 to 6,

**characterized in that**
a load identification module (6) is provided, which determines a load state of the wind energy installation and inhibits the load control module (5) if a threshold is exceeded.

8. Wind energy installation according to one of the Claims 2 to 7,
**characterized in that**
a test control module (7) is provided, which applies a selectable test characteristic to the actuating drive (3).

9. Wind energy installation according to Claim 8,
**characterized in that**
a memory (70) is provided, in which profiles are stored, preferably for a passive resistance, a constant current and a constant power, and/or
the test control module (7) has a modulation degree transmitter (35), which is designed to adjust the current output from the actuating drive (3) such that the desired modulation degree is produced, and/or
the test control module (7) has a measurement unit (72) for detection of actual parameters of the direct current motor (72), and has a compensation unit (73) which compensates for changes in the parameters from a standard value, and/or
the test control module (7) interacts with an excitation switching module (76), which passes current only through a series winding (36), and disconnects a shunt winding (37), and/or
the test control module (7) has a direction selection module (75) which defines a load direction of the blade (14) during operation of the wind energy installation and acts on the test control module such that the actuating drive (3) operates the blade (14) in the opposite direction.

10. Wind energy installation according to Claim 8,
**characterized in that**
the test control module (5) has a brake test unit (74) which produces a specific test torque by means of the actuating drive (3).

11. Wind energy installation according to Claim 10,
**characterized in that**
the brake test unit (74) carries out a bi-directional test by operating the direct current motor (32) in both torque directions against the brake, and wherein a good/bad identification is carried out by means of a classifier.

12. Wind energy installation according to one of the Claims 2 to 11,
**characterized in that**
at least one of the following apparatuses is additionally provided:

a discharge control module (51) which reduces the voltage acting on the actuating drive (3) to a predeterminable voltage level at the test start,
a battery monitor (40) which, in particular, monitors the voltage state of the battery,
a monitoring module (52) which monitors the state, in particular the temperature of the resistance (30) and/or of the direct current motor (32),
a timer (53) in the load control module (5) which carries out a test at predeterminable intervals and monitors timings during testing,
a load identification module (6), which determines a load state of the wind energy installation and inhibits the load control module (5) if a threshold is exceeded,
a monitor module (54) for the battery monitor (40), which monitors its serviceability.

13. Method for monitoring a pitch device for wind energy installations, wherein the pitch device (2) has a battery (21) and an actuating drive (3), and a battery voltage is monitored in the load case during testing,
**characterized in that**
the actuating drive (3) switches between an operating mode and a test mode, wherein, in the test mode, the actuating drive is used under a defined load for the battery (21).

14. Method according to Claim 13,
**characterized by**
use of a monitoring unit according to one of Claims 2 to 12.

**Revendications**

1. Dispositif de surveillance destiné à un dispositif de réglage de pas (2) destiné à des éoliennes comportant une batterie (21) et un mécanisme de réglage (3) muni d'un moteur, **caractérisé en ce qu'**il est prévu un module de commande de charge (5) qui fait basculer le mécanisme de réglage (3) entre un mode de fonctionnement et un mode de test, dans lequel, dans le mode de fonctionnement, le mécanisme de réglage (3) constitue avec son moteur une charge définie d'une manière pouvant être présélectionnée pour la batterie (21).

2. Eolienne comportant un rotor (12), un générateur (15) entraîné par celui-ci afin de générer de l'énergie électrique, dans lequel le rotor (12) comporte au moins une pale (14) réglable au moyen d'un dispositif de réglage de pas (2), et le dispositif de réglage de pas (2) comprend une unité d'alimentation en énergie ayant une batterie (21) et un mécanisme de réglage (3) muni d'un moteur et d'une autre unité de commande (4), **caractérisée en ce qu'**il est prévu un dispositif de surveillance selon la revendication 1.

3. Eolienne selon la revendication 2, **caractérisée en ce que** le mécanisme de réglage (3) comporte une résistance commutable (30) à son entrée et **en ce que** la résistance fonctionne en tant que charge fixe supplémentaire.

4. Eolienne selon la revendication 2 ou 3, **caractérisée en ce que** le mécanisme de réglage (3) comprend un onduleur (31) et un moteur à courant continu (32) et **en ce que** le module de commande de charge (5) est conçu de manière à appliquer au moteur à courant continu (32) un courant pouvant être prédéfini qui correspond à la charge définie.

5. Eolienne selon la revendication 4, **caractérisée en ce qu'**un frein (39) contre lequel le mécanisme de réglage (3) exerce une force, est actionné, et notamment, **en ce que** le module de commande de charge (5) surveille une variation du pas de la pale (14) et délivre un signal d'erreur lorsque le frein (39) est actionné.

6. Eolienne selon l'une quelconque des revendications 2 à 5, **caractérisée en ce qu'**il est prévu un module de commande de délestage (51) qui réduit la tension agissant au début d'un test sur le mécanisme de réglage (3) à un niveau de tension prédéterminé.

7. Eolienne selon l'une quelconque des revendications 2 à 6, **caractérisée en ce qu'**il est prévu un module de détection de charge (6) qui détermine un état de charge de l'éolienne et désactive le module de commande de délestage (5) lors du dépassement d'un seuil.

8. Eolienne selon l'une quelconque des revendications 2 à 7, **caractérisée en ce qu'**il est prévu un module de commande de test (7) qui active une caractéristique de test pouvant être sélectionnée sur le mécanisme de réglage (3).

9. Eolienne selon la revendication 8, **caractérisée en ce qu'**il est prévu une mémoire (50) dans laquelle sont stockés des profils, de préférence destinés à une résistance passive, à un courant constant et à une puissance constante, et/ou **en ce que** le module de commande de test (7) comporte un générateur de taux de modulation (35) qui est conçu pour régler le courant délivré par le mécanisme de réglage (3) de manière à régler le taux de modulation souhaité, et/ou **en ce que** le module de commande de test (7) comporte une unité de mesure (72) destinée à détecter des paramètres effectifs du moteur à courant continu (72) et une unité de compensation (73) qui compense les variations des paramètres par rapport à une valeur normale, et/ou **en ce que** le module de commande de test (7) coopère avec un module de commutation d'excitation (76) qui n'alimente en courant qu'un enroulement série (36) et sépare un enroulement de dérivation (37), et/ou **en ce que** le module de commande de test (7) comporte un module de sélection de direction (75) qui, lors du fonctionnement de l'éolienne, détermine une direction de charge de la pale (17) et agit ainsi sur le module de commande de test de manière à ce que le mécanisme de réglage (3) règle la pale (14) en direction opposée.

10. Eolienne selon la revendication 8, **caractérisée en ce que** le module de commande de test (5) comporte une unité de test de frein (74) qui génère un couple de test déterminé au moyen du mécanisme de réglage (3).

11. Eolienne selon la revendication 10, **caractérisée en ce que** l'unité de test de frein (74) exécute une vérification bidirectionnelle par actionnement du moteur à courant continu (32) dans les deux directions du couple de rotation en s'opposant au frein, et dans lequel une identification d'un état correct/incorrect est effectuée au moyen d'un classificateur.

12. Eolienne selon l'une quelconque des revendications 2 à 11, **caractérisée en ce qu'**il est en outre prévu au moins l'un des dispositifs suivants : un module de commande de délestage (51) qui abaisse au début du test la tension agissant sur le mécanisme de réglage (3) à un niveau de tension prédéterminé ; un dispositif de surveillance de batterie (40) qui surveille la batterie, notamment en ce qui concerne son état de tension ; un module de surveillance (52) qui surveille l'état, notamment la température de la résistance (30) et/ou du moteur à courant continu (32) ; un temporisateur (53), dans le module de commande de charge (5), qui provoque un test à des intervalles pouvant être prédéterminés, et surveille l'évolution temporelle au cours des tests ; un module d'identification de charge (6) qui détermine l'état de charge de l'éolienne et qui désactive le module de commande de charge (5) lors du dépassement d'un seuil ; un module moniteur (54) destiné au dispositif de surveillance de batterie (40), qui surveille le bon fonctionnement de ce dernier.

**13.** Procédé de surveillance d'un dispositif de réglage de pas d'éoliennes, dans lequel le dispositif de réglage de pas (2) comporte une batterie (21) et un mécanisme de réglage (3) et dans lequel, lors de tests, une tension de batterie est surveillée en cas de charge, **caractérisé en ce que** le mécanisme de réglage (3) est amené à basculer entre un mode de fonctionnement et un mode de test, dans lequel, dans le mode de test, le mécanisme de réglage est utilisé sous une charge définie pour la batterie (21).

**14.** Procédé selon la revendication 13, **caractérisé par** l'utilisation d'une unité de commande selon l'une quelconque des revendications 2 à 12.

Fig. 2

Fig. 1

Fig. 4

# Fig. 3

# Fig. 5

a)

b)

c)

d)

**IN DER BESCHREIBUNG AUFGEFÜHRTE DOKUMENTE**

**In der Beschreibung aufgeführte Patentdokumente**

- DE 102005030709
- EP 1739807 A